(19) Europäisches Patentamt

European Patent Office

Office européen des brevets

(19)

(11) Veröffentlichungsnummer: **0 004 969**
**B1**

## (12) EUROPÄISCHE PATENTSCHRIFT

(45) Veröffentlichungstag der Patentschrift: **28.07.82**

(21) Anmeldenummer: **79101175.2**

(22) Anmeldetag: **17.04.79**

(51) Int. Cl.³: **G 01 R 31/00,** G 08 G 1/12,
G 01 R 31/36

(54) Einrichtung zur automatischen Überwachung des Ladezustandes netzunabhängiger Stromversorgungen.

(30) Priorität: **18.04.78 DE 2816781**

(43) Veröffentlichungstag der Anmeldung:
**31.10.79 Patentblatt 79/22**

(45) Bekanntmachung des Hinweises auf die Patenterteilung:
**28.07.82 Patentblatt 82/30**

(84) Benannte Vertragsstaaten:
**BE CH FR GB IT NL SE**

(56) Entgegenhaltungen:
**DE - A - 2 022 447**
**DE - A - 2 136 321**
**DE - A - 2 558 805**
**DE - B - 1 574 122**

**IEEE TRANSACTIONS ON VEHICULAR
TECHNOLOGY, Vol. VT-19, Nr. 1,
Februar 1970,
W. V. BRAUN et al.: "Vehicular location and
information systems", Seiten 136—143.**

(73) Patentinhaber: **SIEMENS AKTIENGESELLSCHAFT
Berlin und München
Postfach 22 02 61
D-8000 München 22 (DE)**

(72) Erfinder: **Hildebrandt, Bernhard
Kirchstrasse 15
D-8046 Hochbrück (DE)**

Courier Press, Leamington Spa, England.

## Einrichtung zur automatischen Überwachung des Ladezustandes netzunabhängiger Stromversorgungen

Die Erfindung bezieht sich auf eine Einrichtung zur automatischen Überwachung des Ladezustandes der netzunabhängigen Stromversorgung des stationären Antwortgerätes einer Anlage zur Standortbestimmung von Verkehrseinrichtungen, das mit einem in der Verkehrseinrichtung installierten Abfragegerät in Funkkontakt steht und wechselseitig Datentelegramme austauscht.

Punktförmige Ortungssysteme, die z.B. zur Standortbestimmung von Verkehrseinrichtungen eingesetzt sind, bestehen im wesentlichen aus zwei Einheiten, nämlich einem Abfragegerät und einem Antwortgerät. Die Abfragegeräte werden im allgemeinen mit Strom aus dem Bordnetz der Verkehrseinrichtung betrieben. Die Energieversorgung der Antwortgeräte aus einem Stromnetz ist mit einem hohen Aufwand für die Installation verbunden. Es ist daher vorgesehen, diese aus Primärbatterien oder aus Akkumulatoren mit Ladung über Solarzellen zu betreiben. Störungen in der Stromversorgung, beispielsweise entladene Batterien, werden durch fehlende Datensendung des jeweiligen Antwortgeräts erkannt und können nur über eine Plausibilitätskontrolle der Reihenfolge der Antwortgerätedaten an der Strecke in einer Zentrale festgestellt werden. Der Übergangszustand der Batterieladung von voll nach leer wird dabei nicht erkannt. Entsprechend der jeweiligen Verkehrsdichte wird die Batteriebelastung der Antwortgeräte längs einer Strecke unterschiedlich sein. Antwortgeräte z.B. an Kreuzungen und Plätzen werden häufiger abgefragt als solche, die z.B. an einbahnigen Straßen montiert sind.

Ein Fahrzeuglokalisierungs- und Informationssystem, bei dem ein Informationsaustausch zwischen Feststationen und Fahrzeugen erfolgt, ist beispielsweise durch IEEE Trans. on Vehicular Technology, Vol. VT-19, No. 1, Februar 1970, S. 136—143 bekannt. Dabei werden der Standort des betreffenden Fahrzeuges ermittelt und auch betriebstechnische Daten des Fahrzeuges an die Feststation übermittelt. Ein wechselseitiger Austausch von Datentelegrammen ist dabei nicht vorgesehen.

Durch die DE—A 21 36 321 ist ein Verfahren zum Überwachen von Fahrzeugen bekannt, bei dem zwischen den verschiedenen Fahrzeugen und einer allen Fahrzeugen gemeinsamen Leitstelle wechselseitig Datentelegramme ausgetauscht werden. Jedem Fahrzeug ist eine erste, variable und eine zweite, unveränderbare Ziffernfolge zugeordnet. Änderungen der variablen, z.B. von der jeweiligen Liniennummer und der jeweiligen Kursnummer abhängigen Ziffernfolge werden mit einem Rücktelegramm an die zentrale Funkstation übermittelt. Bei den an die zentrale Funkstation übermittelten Informationen handelt es sich also ausschließlich um solche des Fahrzeuges selbst. Eine automatische Überwachung einer netzunabhängigen Stromversorgung einer stationären Einrichtung ist weder bei diesem Verfahren noch bei dem Fahrzeuglokalisierungs- und Informationssystem nach IEEE Trans. on Vehicular Technology vorgesehen.

Durch die DE—A 25 58 805 ist eine Einrichtung bekannt, die allein der Überwachung einer Batteriespannung dient, bei der die Kontrollanzeige der Batteriespannung in unmittelbarer Nähe der Batterie über eine Kontroll-leuchte erfolgt.

Der Erfindung liegt die Aufgabe zugrunde, für eine Anlage der eingangs beschriebenen Art eine Einrichtung zur automatischen Überwachung des Ladezustandes der netzunabhängigen Stromversorgung des Antwortgerätes zu schaffen.

Diese Aufgabe wird gemäß der Erfindung in der Weise gelöst, daß der Stromversorgung, bestehend aus Primärbatterien oder Akkumulatoren mit Ladung über Solarzellen, ein Überwachungssensor zugeordnet ist mit einer Ansprechschwelle zur Abgabe eines Alarmsignals, die um einen definiert einstellbaren Wert über der für den ungestörten Betrieb erforderlichen Mindestspannung liegt, und daß das Ergebnis der bei jedem Abfragevorgang des Abfragegerätes durchgeführten Messung der Spannung als Überwachungssignal einem Telegrammregister zugeführt und in codierter Form dem von Antwortgerät an das Abfragerät übermittelten, die Streckendaten enthaltenden Telegramm beigefügt ist.

Nachstehend wird die Erfindung anhand eines in den Figuren dargestellten Ausführungsbeispiels näher erläutert.

Es zeigen:

Fig. 1 in einer grafischen Darstellung den Verlauf der Batteriespannung über der Zeit,

Fig. 2 eine Überwachungsschaltung im Antwortgerät und

Fig. 3 ein Telegramm des Antwortgerätes.

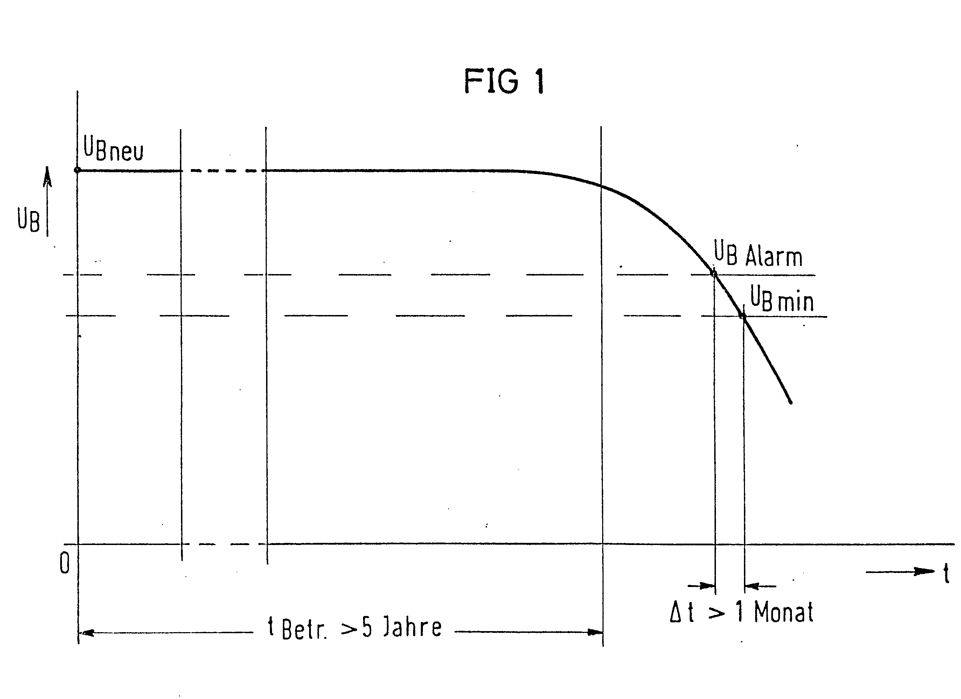

In dem Diagramm nach Fig. 1 ist die Batteriespannung $U_B$ in Abhängigkeit von der Betriebsdauer, d.h. von der Zeit t dargestellt. Es ist dabei angenommen, daß die Batterie während einer Betriebszeit $t_{Betr}$ von wenigstens 5 Jahren eine annähernd konstante Spannung liefert. Danach setzt ein stärkerer Abfall der Spannung ein. In dem abfallenden Ast der Spannungskurve sind zwei Punkte eingezeichnet für eine Batteriespannung $U_{B\ Alarm}$ und $U_{B\ min}$. Beide Punkte liegen, bezogen auf die Zeitachse, um eine Zeit $\Delta t > 1$ Monat auseinander. Dieser Wert wird angenommen bei Langzeitbatterien mit Niedrigstrombelastung. Der Wert $U_{B\ Alarm}$ ist dabei derjenige Spannungswert, bei dessen Erreichen ein Alarmsignal gegeben wird. Dieser Wert kann entsprechend eingestellt werden und wird so gewählt, daß ein genügend langer Zeitraum verbleibt, bis die Spannung auf den Wert $U_{B\,min}$ abgesunken ist, nach dessen Unterschreitung ein ungestörter Betrieb der Anlage nicht mehr gegeben ist. Innerhalb des Zeitraumes $\Delta t$ wird die Batterie im Antwortgerät ausgewechselt. Dadurch ist also eine optimale Batterienutzung und eine Vereinfachung der Wartung gewährleistet. Ferner wird die Betriebszuverlässigkeit und die Verfügbarkeit des Gesamtsystems erheblich gesteigert.

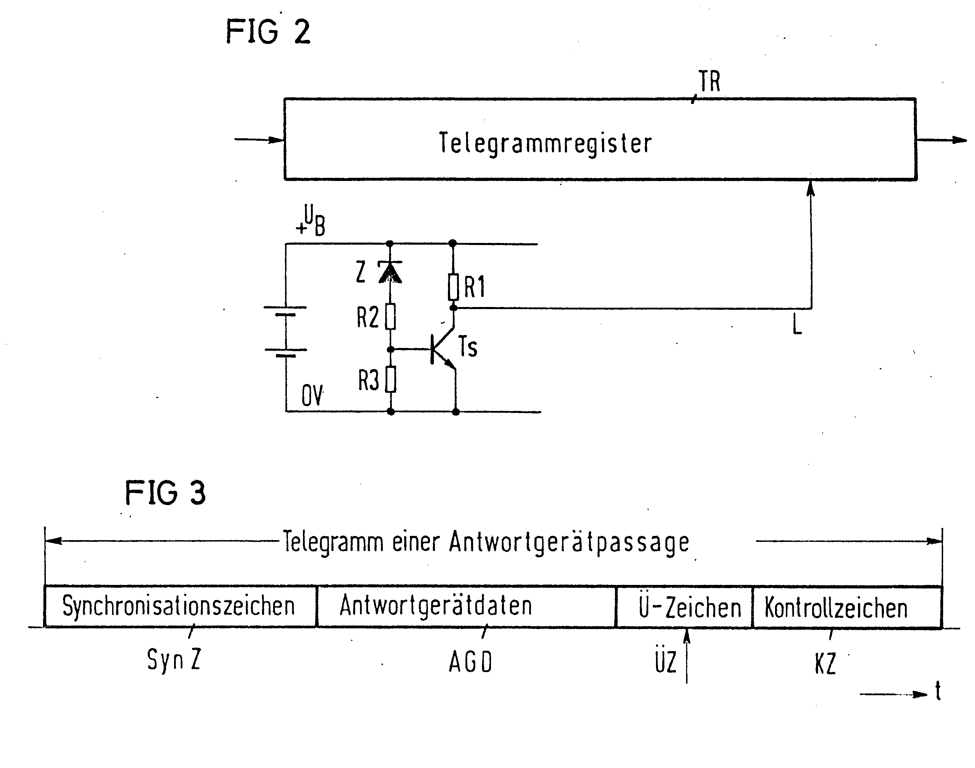

Fig. 2 zeigt die Batterie-Überwachungsschaltung des Antwortgerätes. Dabei ist parallel zur Batterie mit den Klemmen $+U_B$ und O ein Transistor Ts geschaltet mit einem Spannungsteiler aus den Widerständen R2 und R3 im Basiskreis, einer in Reihe mit dem einen Widerstand R2 liegenden Zenerdiode Z und einem Widerstand R1 im Kollektorkreis. Vom Kollektor des Transistors Ts führt eine Leitung L zu einem Telegrammregister TR. Über diese Leitung L gelangt ein Überwachungssignal zum Telegrammregister. Die Bemessung der Überwachungsschaltung ist dabei so gewählt, daß bei Erreichen der Spannung $U_{B\,Alarm}$ der Transistor sperrt. Somit wird also aus dem Vorhandensein bzw. Nichtvorhandensein eines Stromes durch den Transistor ein Signal über die Höhe der Batteriespannung abgeleitet.

In dem Telegrammregister TR wird das Überwachungszeichen dem Telegramm des Antwortgerätes hizugefügt. In Fig. 3 ist ein solches Telegramm dargestellt, das aus mehreren aneinander gefügten Blöcken besteht, nämlich dem Synchronisationszeichen SynZ, den Antwortgerätedaten AGD, dem Überwachungszeichen ÜZ und einem Kontrollzeichen KZ. Auf jede Anfrage des Abfragegerätes wird diesem ein solches Telegramm vom Antwortgerät übermittelt. Das Ergebnis der bei jedem Abfragevorgang durchgeführten Messung der Batteriespannung ist also in jedem Telegramm des Antwortgerätes enthalten. Die Zentrale ist somit ständig über mögliche Störungen der Batteriespannung informiert.

In einer teilweisen Abwandlung hierzu kann das Überwachungssignal auch mit einem besonderen Abfragesignal von einem Servicewagen vom Antwortgerät abgefragt werden.

## Patentansprüche

1. Einrichtung zur automatischen Überwachung des Ladezustandes der netzunabhängigen Stromversorgung des stationären Antwortgerätes einer Anlage zur Standortbestimmung von Verkehrseinrichtungen, das mit einem in der Verkehrseinrichtung installierten Abfragegerät in Funkkontakt steht und wechselseitig Datentelegramme austauscht, dadurch gekennzeichnet, daß der Stromversorgung, bestehend aus Primärbatterien oder Akkumulatoren mit Ladung über Solarzellen, ein Uberwachungssensor (Ts, Z, R1, R2, R3) zugeordnet ist mit einer Ansprechschwelle ($U_B$ Alarm) zur Abgabe eines Alarmsignales, die um einen definiert einstellbaren Wert über der für den ungestörten Betrieb erforderlichen Mindestspannung ($U_B$ min) liegt, und daß das Ergebnis der bei jedem Abfragevorgang des Abfragegerätes durchgeführten Messung der Spannung ($U_B$) als Überwachungssignal einem Telegrammregister (TR) zugeführt und in codierter Form dem vom Antwortgerät an das Abfragegerät übermittelten, die Streckendaten enthaltenden Telegramm beigefügt ist.

2. Einrichtung nach Anspruch 1, dadurch gekennzeichnet, daß das Überwachungssignal mit einem besonderen Abfragesignal von einem Servicewagen vom Antwortgerät abgefragt wird.

## Claims

1. Device for automatically monitoring the load state of the mains-independent current supply of the stationary response apparatus of a system of the position finding of traffic devices, which response apparatus is in contact with and mutually exchanges data telegrams with an interrogation apparatus which is installed in the traffic device, characterised in that the current supply unit consisting of primary batteries or accumulators with charging from solar cells is assigned a monitoring sensor (Ts, Z, R1, R2, R3) which has a response threshold ($U_B$ alarm) which serves to emit an alarm signal and lies, by a defined adjustable value, above the minimum voltage ($U_B$ min) which is required for undisturbed operation, and that the result of the measurement of the voltage ($U_B$) which is carried out in each interrogation process of the interrogation apparatus is fed to a telegram register (TR) as a monitoring signal and added to the telegram, which contains the link data and has been transmitted to the interrogation apparatus by the response apparatus, in a coded form.

2. Device as claimed in Claim 1, characterised in that the monitoring signal is interrogated from the response apparatus by means of a particular interrogation signal from a service vehicle.

## Revendications

1. Installation pour surveiller automatiquement l'état de charge de l'alimentation, indépendante du réseau, du répondeur fixe d'une installation pour déterminer le point d'implantation d'installations routières, répondeur qui est en contact radioélectrique avec un appareil d'interrogation monté dans l'installation routière et avec lequel il échange alternativement des télégrammes de données, caractérisée par le fait qu'à l'alimentation en courant qui est contrôlée par des batteries primaires ou par des accumulateurs chargés par des cellules solaires, est associé un détecteur de surveillance (Ts, Z, R1, R2, R3) à seuil de réponse ($U_{B\,Alarme}$) pour émettre un signal d'alarme et qui se situe d'une valeur déterminée réglable au-delà de la tension minimale ($U_{B\,min}$) qui est nécessaire pour le fonctionnement non perturbé, et que le résultat de la mesure de la tension ($U_B$) exécutée à chaque opération d'interrogation de l'appareil d'interrogation est appliqué, en tant que signal de surveillance, à un registre de télégrammes (TR) et ajouté sous forme codée au télégramme qui est transmis en répondeur par l'appareil d'interrogation et qui contient les données de la voie.

2. Installation selon la revendication 1, caractérisée par le fait que le signal de surveillance est interrogé par le répondeur par un signal d'interrogation particulier de la voiture de service.

FIG 1

0 004 969

# FIG 2

Telegrammregister — TR

L

$+U_B$

Z  R1  R2  Ts  R3

0V

# FIG 3

Telegramm einer Antwortgerätpassage

| Synchronisationszeichen | Antwortgerätdaten | Ü-Zeichen | Kontrollzeichen |
| --- | --- | --- | --- |
| Syn Z | AGD | ÜZ | KZ |

t